# EUROPEAN PATENT APPLICATION

(11) **EP 4 199 027 A1**
(43) Date of publication of application: **21.06.2023**
(21) Application number: 21215703.6
(22) Date of filing: 17.12.2021
(51) Int. Cl.: H01J 37/04

(54) **CHARGED-PARTICLE APPARATUS, MULTI-DEVICE APPARATUS, METHOD OF USING CHARGED-PARTICLE APPARATUS AND CONTROL METHOD**

(71) Applicant: ASML Netherlands B.V., 5500 AH Veldhoven (NL)
(72) Inventor: REN, Yan, 5500 AH Veldhoven (NL); MANGNUS, Albertus, Victor, Gerardus, 5500 AH Veldhoven (NL); SCOTUZZI, Marijke, 5500 AH Veldhoven (NL); SMAKMAN, Erwin, Paul, 5500 AH Veldhoven (NL)
(74) Representative: ASML Netherlands B.V.

(57) **Abstract**

A charged-particle apparatus generates a plurality of sub-beams from a source beam of charged particles and direct the sub-beams downbeam toward a sample position. The charged-particle apparatus comprises a charged particle source, an aperture array and a charged particle optical component. The charged-particle source comprises an emitter to emit a source beam of charged particles along a divergent path. The aperture array is positioned in the divergent path so the aperture array generates sub-beams from the source beam. The charged-particle-optical component acts on the source beam upbeam of the aperture array. The charged-particle-optical component comprises a multipole and/or a charged-particle lens. The multipole operates on the source beam to vary the position of the divergent path at the aperture array. The multipole may vary a cross-sectional shape of the divergent path at the aperture array. The charged-particle-optical lens compensates for variations in distance between the emitter and the aperture array.

## Description

### FIELD

The embodiments provided herein generally relate to charged-particle apparatuses and projection methods, and particularly to charged-particle apparatuses and projection methods that use multiple sub-beams of charged particles.

### BACKGROUND

When manufacturing semiconductor integrated circuit (IC) chips, undesired pattern defects often occur on a substrate (i.e. wafer) or a mask during the fabrication processes, thereby reducing the yield. Such defects can occur as a consequence of, for example, optical effects and incidental particles as well as in subsequent processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve characteristics of a charged-particle apparatus. In particular, it is desirable to control various characteristics of the beam of charged particles. The process of operating on the beam of charged particles to control various characteristics needs to be improved.

### SUMMARY

The embodiments provided herein disclose a charged-particle apparatus, a multi-device apparatus, a method of using a charge-particle apparatus and a method of controlling a divergent path of a charged particle beam.

According to a first aspect of the invention, there is provided a charged-particle apparatus configured to generate a plurality of sub-beams from a source beam of charged particles and direct the sub-beams downbeam toward a sample position, the charged-particle apparatus comprising;
a charged-particle source comprising an emitter configured to emit a source beam of charged particles along a divergent path;
an aperture array in which are defined apertures and positioned in the divergent path, the aperture array configured to generate sub-beams from the source beam; and
at least one charged-particle-optical component configured to act on the source beam of charged particles upbeam of the aperture array;
wherein the at least one charged-particle-optical component comprises:
   at least one multipole configured to operate on the source beam so as to vary the position of the divergent path at the aperture array and/or to vary a cross-sectional shape of the divergent path at the aperture array, and/or
   a charged-particle-optical lens configured to compensate for variations in distance between the emitter and the aperture array.

According to a second aspect of the invention, there is provided a charged-particle apparatus configured to generate a plurality of sub-beams from a divergent beam of charged particles and direct the sub-beams downbeam toward a sample position, the charged-particle apparatus comprising;
a charged-particle source comprising an emitter configured to emit a beam of charged particles along a divergent path;
an aperture array in which are defined apertures and positioned in the divergent path, the aperture array configured to generate sub-beams from the beam along the divergent path; and
at least one charged-particle-optical component configured to act on the beam of charged particles upbeam of the aperture array;
wherein the at least one charged-particle-optical component is configured to operate on the divergent path of the beam so as to vary the position of the divergent path at the aperture array, to vary a cross-sectional shape of the path of the charged particle beam at the aperture array, and/or to compensate for variations in distance between the emitter and the aperture array.

According to a third aspect of the invention, there is provided a charged-particle apparatus configured to generate a plurality of sub-beams from a divergent beam of charged particles and direct the sub-beams downbeam toward a sample position, the charged-particle apparatus comprising;
a charged-particle source comprising an emitter configured to emit a beam of charged particles along a divergent path;
an aperture array in which are defined apertures and positioned in the divergent path, the aperture array configured to generate sub-beams from the beam along the divergent path; and
at least one charged-particle-optical component configured to act on the beam of charged particles upbeam of the aperture array;
wherein the at least one charged-particle-optical component comprises: at least a multipole arranged around the divergent path configured to operate as a deflector and/or as a stigmator of the divergent path of the charged particle beam; and/or two facing surfaces around the divergent beam path configured to operate as a charged-particle-optical lens.

According to a fourth aspect of the invention, there is provided a multi-device apparatus comprising multiple devices each configured to project a plurality of sub-beams of charged particles towards a sample position, the multi-device apparatus comprising a charged-particle apparatus as described in this document comprising a plurality of the sources and a plurality of corresponding charged-particle devices each comprising the aperture array and the at least one charged-particle-optical component.

According to a fifth aspect of the invention, there is provided a method of using a charged-particle apparatus to generate a plurality of sub-beams from a source beam of charged particles and direct the sub-beams downbeam toward a sample position, the method comprising;
emitting a source beam of charged particles along a divergent path;
generating sub-beams from the source beam at an aperture array; and
using a charged-particle-optical component to act on the divergent path upbeam of the aperture array;
wherein the at least one charged-particle-optical component comprises:
   at least one multipole configured to operate on the source beam so as to vary the position of the divergent path at the aperture array and/or to vary a cross-sectional shape of the divergent path at the aperture array, and/or
   a charged-particle-optical lens configured to compensate for variations in distance between the emitter and the aperture array.

According to a sixth aspect of the invention, there is provided a method of controlling a divergent path of a charged particle beam over an aperture array for generating a plurality of sub-beams toward a sample position in a charged-particle apparatus, the method comprising;
emitting a beam of charged particles along a divergent path;
operating on the divergent path upbeam of an aperture array in which are defined a plurality of apertures, each aperture corresponding to a generated sub-beam; and
generating sub-beams from the divergent beam at the aperture array;
wherein the operating on the divergent path comprises at least one of varying a position of the divergent path at the beam generator, compensating variations in distance between the emitter and the aperture array, and varying a shape of the divergent beam at the aperture array.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1**.
**FIG. 3** is a schematic diagram of exemplary multi-beam apparatus according to an embodiment.
**FIG. 4** is a schematic cross-sectional view of an objective lens of an inspection apparatus according to an embodiment.
**FIG. 5** is a bottom view of the objective lens of **FIG. 4**.
**FIG. 6** is a bottom view of a modification of the objective lens of **FIG. 4**.
**FIG. 7** is an enlarged schematic cross-sectional view of a detector incorporated in the objective lens of **FIG. 4**.
**FIG. 8** is a schematic diagram illustrating example positions for the converters.
**FIG. 9** is a schematic diagram illustrating a portion of an electron-optical device comprising a plurality of converters and a light guiding arrangement.
**FIG. 10** is a schematic diagram of an exemplary charged-particle apparatus according to an embodiment.
**FIG. 11** is a schematic diagram of an exemplary charged-particle apparatus according to an embodiment.
**FIG. 12** is a schematic diagram of an exemplary charged-particle apparatus according to an embodiment.
**FIG. 13** is a schematic diagram of an exemplary charged-particle apparatus according to an embodiment.
**FIG. 14** is a schematic diagram of an exemplary charged-particle apparatus according to an embodiment.
**FIG. 15** is a schematic diagram of a source beam incident on an aperture array.
**FIG. 16** is a schematic diagram of a source beam incident on an aperture array.
**FIG. 17** is a schematic diagram of e a source beam incident on an aperture array.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system (or electron optical apparatus). The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus (or electron apparatus), it is appreciated that the embodiments are not used to limit the present disclosure to specific charged particles. References to electrons throughout the present document may therefore be more generally be considered to be references to charged particles, with the charged particles not necessarily being electrons.

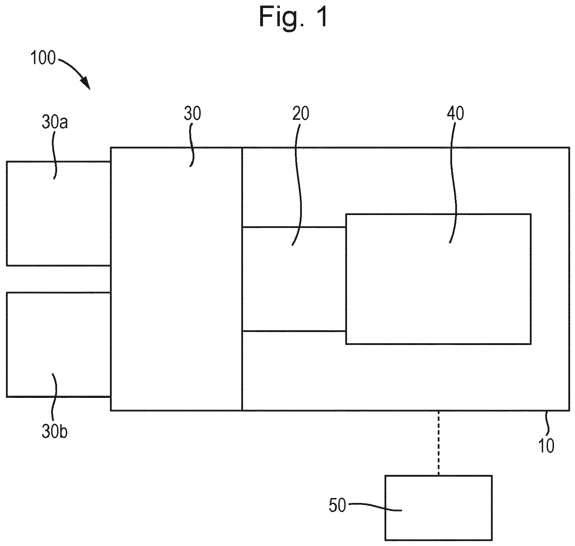

Reference is now made to **FIG. 1**, which is a schematic diagram illustrating an exemplary charged particle beam inspection apparatus 100. The charged particle beam apparatus 100 (for example a charged particle beam apparatus 100) of **FIG. 1** includes a main chamber 10, a load lock chamber 20, an electron beam tool or apparatus 40, an equipment front end module (EFEM) 30 and a controller 50. The electron beam apparatus 40 is located within main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical device 41.

The controller 50 is electronically connected to electron beam tool or apparatus 40. The controller 50 may be a processor (such as a computer) configured to control the charged particle beam apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam apparatus or it can be distributed over at least two of the component elements. While the present disclosure provides examples of the main chamber 10 housing an electron beam apparatus, it should be noted that aspects of the disclosure in their broadest sense are not limited to a chamber housing an electron beam apparatus. Rather, it is appreciated that the foregoing principles may also be applied to other tools and other arrangements of apparatus, that operate under the second pressure.

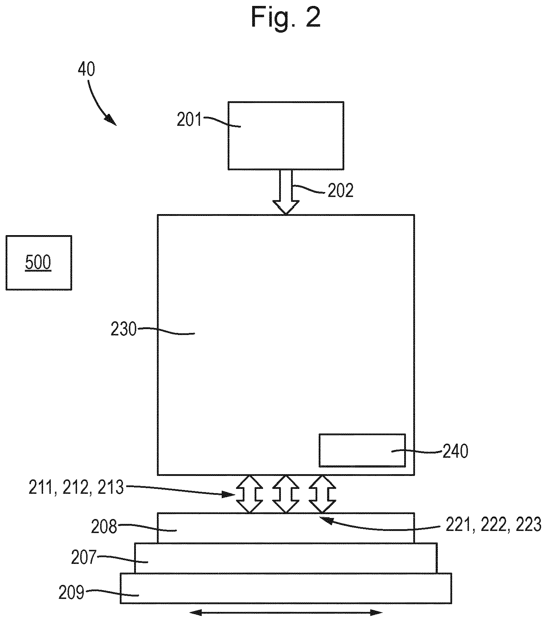

Reference is now made to **FIG. 2**, which is a schematic diagram illustrating an exemplary electron beam apparatus 40 including a multi-beam apparatus which may be a multi-beam inspection tool that is part of the exemplary charged particle beam apparatus 100 of **FIG. 1**. The multi-beam electron beam tool 40 (also referred to herein as apparatus 40) comprises a projection apparatus 230 (or an electron-optical device 41), an electron source 201, a motorized stage 209, and a sample holder 207. The electron-optical device 41 optionally comprises the electron source 201. The electron source 201 and the projection apparatus 230 may together be referred to as an illumination apparatus. The sample holder 207 is supported by the motorized stage 209 so as to hold a sample 208 (e.g., a substrate or a mask) for inspection. The multi-beam electron beam apparatus 40 further comprises an electron detection device 240.

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a source beam (or primary electron beam) 202.

The projection apparatus 230 is configured to convert the source beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam apparatus 100 of **FIG. 1**, such as the electron source 201, the electron detection device 240, the projection apparatus 230, and the motorized stage 209. The controller 50 may perform various image and signal processing functions. The controller 50 may also generate various control signals to govern operations of the charged particle beam apparatus, including the charged particle multi-beam apparatus.

The projection apparatus 230 may be configured to focus the sub-beams 211, 212, and 213 onto a sample 208 for assessment, for example inspection, and may form three probe spots 221, 222, and 223 on the surface of the sample 208. The projection apparatus 230 may be configured to deflect the primary sub-beams 211, 212, and 213 to scan the probe spots 221, 222, and 223 across individual scanning areas in a section of the surface of sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV and backscattered electrons typically have electron energy between 50 eV and the landing energy of the primary sub-beams 211, 212, and 213.

The electron detection device 240 is configured to detect secondary electrons and/or backscattered electrons and to generate corresponding signals which are sent to the controller 50 or a signal processing system (not shown), e.g. to construct images of the corresponding scanned areas of the sample 208. Desirably, the electron detection device is incorporated into the projection apparatus. Alternatively it may be separate therefrom, with a secondary electron-optical column (or device) being provided to direct secondary electrons and/or backscattered electrons to the electron detection device.

The controller 50 may comprise an image processing system that includes an image acquirer (not shown) and a storage device (not shown). For example, the controller may comprise a processor, a computer, a server, a mainframe host, terminals, a personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. The acquired images may comprise multiple images of a single imaging area of the sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of the primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move the sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

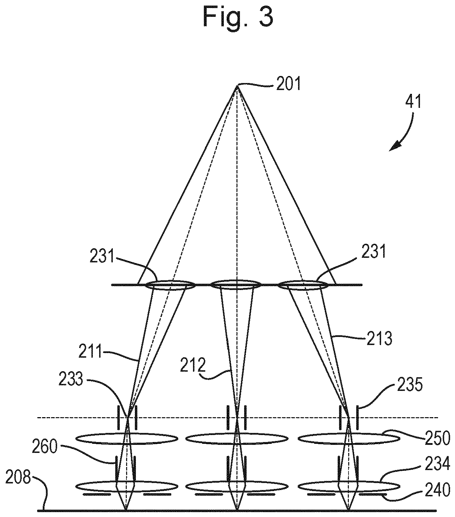

**FIG. 3** is a schematic diagram of a part of an electron beam apparatus for example an assessment tool comprising an electron source 201 and an electron optical device 41 (or electron optical column). (In another arrangement the source is part of the electron-optical device). The electron optical device comprises a plurality of electron optical elements. An electron optical element is any element that affects (e.g. directs, shapes or focuses) an electron beam and may use electric and/or magnetic fields. The electron source 201 directs electrons toward an array of condenser lenses 231 forming part of the electron optical device. The electron source is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array therefore functions as a beam divider, beam splitter, beam generator or beam separator. The condenser lens array may take the form of at least two plates, acting as electrodes, with an aperture in each plate aligned with each other and corresponding to the location of a sub-beam. At least two of the plates are maintained during operation at different potentials to achieve the desired lensing effect. The plates therefore have an array of apertures, each aperture corresponding to the path of a sub-beam. The plate positioned most up beam is an aperture array configured to function as the beam separator and may referred to as a beam limiting aperture. In a different arrangement the beam separator may be part of or associated with the condenser lens array, with a separate function from lensing the sub-beams. Between the plates of the condenser lens array, and indeed between other electrodes along the path of the charged particle beam, are electrically insulating plates for example made of an insulating material such as ceramic or glass, with one or more apertures for the sub-beams.

In an arrangement the condenser lens array is formed of three plate arrays in which charged particles have the same energy as they enter and leave each lens, which arrangement may be referred to as an Einzel lens. The beam energy is the same on entering as leaving the Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. The sub-beams diverge with respect to each other. At the intermediate focuses 233 are deflectors 235. The deflectors 235 are positioned in the beamlet paths at, or at least around, the position of the corresponding intermediate focusses 233 or focus points (i.e. points of focus). The deflectors are positioned in the beamlet paths at the intermediate image plane of the associated beamlet, i.e. at its focus or focus point. The deflectors 235 are configured to operate on the respective beamlets 211, 212, 213. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the beamlets so that upbeam of the deflectors, the beamlet paths with respect to each other are diverging. Downbeam of the deflectors the beamlet paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array.

Below (i.e. downbeam or further from the source 201) deflectors 235 there is a control lens array 250 comprising a control lens 251 for each sub-beam 211, 21, 213. The control lens array 250 may comprise at least two, for example three, plate electrode arrays connected to respective potential sources. A function of the control lens array 250 is to optimize the beam opening angle with respect to the demagnification of the beam and/or to control the beam energy delivered to objective lenses 234, each of which directs a respective sub-beam 211, 212, 213 onto the sample 208. The control lenses pre-focus the sub-beams (e.g. apply a focusing action to the sub-beams prior to the sub-beams reaching the objective lenses 234). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. Note that the reference to demagnification and opening angle is intended to refer to variation of the same parameter. In an ideal arrangement the product of demagnification and the corresponding opening angle is constant over a range of values.

The objective lenses 234 are arranged in an objective lens array. The objective lenses 234 can be configured to demagnify the electron beam by a factor greater than 10, desirably in the range of 50 to 100 or more. The objective lenses 234 may be Einzel lenses. At least the chromatic aberrations generated in a beam by a condenser lens and the corresponding downbeam objective lens may mutually cancel.

An electron detection device 240 is provided between the objective lenses 234 and the sample 208 to detect secondary and/or backscattered electrons emitted from the sample 208. An exemplary construction of the electron detection system is described below.

Optionally an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The electron-optical device of **FIG. 3** can be configured to control the landing energy of the electrons on the sample. The landing energy can be selected to increase emission and detection of secondary electrons dependent on the nature of the sample being assessed. A controller provided to control the objective lenses 234 may be configured to control the landing energy by varying the potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. A controller may be configured to control the landing energy to any desired value within a predetermined range or to a desired one of a plurality of predetermined values. In an embodiment, the landing energy can be controlled to desired value in the range of from 1000 eV to 5000 eV.

Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can also be referred to as a refocus lens as it can function to correct the focus position in view of changes in the landing energy. The use of the control lens array enables the objective lens array to be operated at its optimal electric field strength. Details of electrode structures and potentials that can be used to control landing energy are disclosed in EPA 20158804.3, which document is incorporated herein by reference.

The landing energy of the electrons may be controlled in the system of **FIG. 3** because any off-axis aberrations generated in the beamlet path are generated in, or at least mainly in, the condenser lenses 231. The objective lenses 234 of the system shown in **FIG. 3** need not be Einzel lenses. This is because, as the beams are collimated, off-axis aberrations would not be generated in the objective lenses. The off-axis aberrations can be controlled better in the condenser lenses than in the objective lenses 234. By making the condenser lenses 231 substantially thinner the contributions of the condenser lenses to the off-axis aberrations, specifically the chromatic off-axis aberrations, may be minimized. The thickness of the condenser lens 231 may be varied to tune the chromatic off-axis contribution balancing other contributions of the chromatic aberrations in the respective beamlet paths. Thus the objective lenses 234 may have two or more electrodes. The beam energy on entering an objective lens can be different from its energy leaving the objective lens, for example to provide a decelerating objective lens. Further in using two electrodes as few electrodes are used as possible, enabling the lens array to take a smaller volume.

In some embodiments, the charged particle device 41 further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane or focus points) comprise deflectors to correct for the source 201 appearing to be at different positions for different beams. Correctors can be used to correct macroscopic aberrations resulting from the source that prevent a good alignment between each sub-beam and a corresponding objective lens. In some circumstances it is desirable to position the correctors as far upbeam as possible. In this way, a small angular correction can effect a large displacement at the sample so that weaker correctors can be used. Desirably the correctors are positioned to minimize introduction of additional aberrations.

The aberration correctors may correct other aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses 231 are vertically close or coincident with the beam apertures. That is, correction by the corrector of any angular error will require a smaller positional shift than if the corrector is positioned further downbeam. Correcting such aberrations further downbeam such as at the intermediate foci may be impacted by misalignment between the sub-beams 211, 212, 213 and the correctors. A challenge with positioning correctors at or near the condenser lenses 231, however, is that the sub-beams each have relatively large sectional areas and relatively small pitch at this location, relative to locations further downbeam. In situations with volume restrictions, the corrector array or additional corrector arrays may be located away from these preferred locations, such as between the condenser lens array and the intermediate focus positions.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. There may be an aberration corrector of this design for each beamlet, i.e. an individual beamlet corrector. The individual beamlet correctors may be in an array across the multi-beam, which may be referred to as a corrector array.

In an embodiment the objective lens array referred to in earlier embodiments is an array objective lens. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an two electrode decelerating lens. Each electrode may in its own right be considered as a lens; each electrode may be considered an electron-optical element (or electron-optical component). Between the plates (for example electrodes) of the objective lens array are electrically insulating plates for example made of an insulating material such as ceramic or glass, with one or more apertures for the sub-beams.

The bottom electrode of the objective lens is a chip detector such as a CMOS chip detector integrated into a multi-beam manipulator array. Integration of a detector array into the objective lens replaces a secondary column. The chip is preferably orientated to face the sample (because of the small distance (e.g. 100µm) between sample and bottom of the electron-optical system). In an embodiment, capture electrodes to capture the secondary electron signals are provided. The capture electrodes can be formed in the metal layer of a device on and/or in the chip, for example, a CMOS device. The capture electrode may form the bottom layer of the objective lens. The capture electrode may form the bottom surface in the detector chip, e.g. a CMOS chip. The CMOS chip may be a CMOS chip detector. The chip e.g. the CMOS chip may be integrated into the sample facing surface of an objective lens assembly. The capture electrodes are examples of sensor units for detecting secondary electrons. The capture electrodes can be formed in other layers. Power and control signals of the integrated device on the chip, e.g. the CMOS may be connected to the integrated devices by through-silicon vias. For robustness, preferably the bottom electrode consist of two elements: the chip and a passive plate, for example comprising silicon, with holes. The plate shields the chip (at least the integrated devices) from high E-fields.

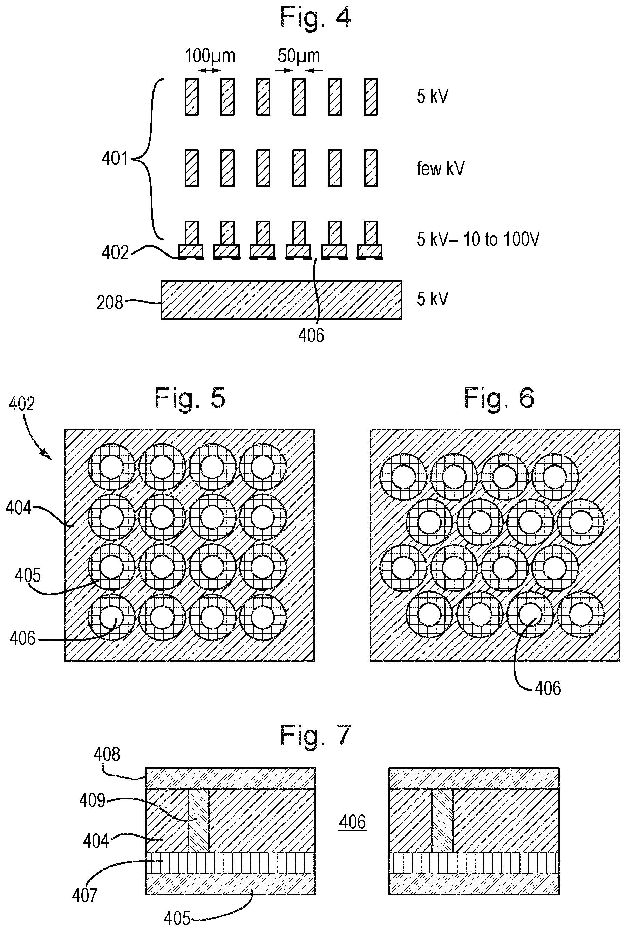

An exemplary embodiment is shown in **FIG. 4** which illustrates a multibeam objective lens 401 in schematic cross section. On the output side of the objective lens 401, the side facing the sample 208, a detector module 402 is provided. The detector module 402 is an example of an electron detection device. **FIG. 5** is a bottom view of detector module 402 which comprises a substrate 404 on which are provided a plurality of capture electrodes 405 each surrounding a beam aperture 406. Beam apertures 406 are large enough not to block any of the primary electron beams. Capture electrodes 405 can be considered as examples of sensor units which receive back-scattered or secondary electrodes and generate a detection signal, in this case an electric current. The beam apertures 406 may be formed by etching through substrate 404. In the arrangement shown in **FIG. 5**, the beam apertures 406 are shown in a rectangular array. The beam apertures 406 can also be differently arranged, e.g. in a hexagonal close packed array as depicted in **FIG. 6**.

**FIG. 7** depicts at a larger scale a part of the detector module 402 in cross section. Capture electrodes 405 form the bottommost, i.e. most close to the sample, surface of the detector module 402. In operation, the array of capture electrodes 405 face the sample 208. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallization layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

**FIG. 4** depicts a three-electrode objective lens but it will be appreciated that any other form of objective lens, e.g. as few as two-electrode lens, may also be used. In an arrangement additional plates for example planar electrodes may be associated plates associated with the objective lens array desirably upbeam of the objective lens array and proximate to the objective lens array. As noted such plates may each function as a lensing element. Such associated plates may contribute an additional degree of freedom to the objective lens for controlling electron-optical parameters and properties of the charged particle beam. The control lens array may be an example of a number of such associated plates.

In an alternative embodiment the condenser lens array may not be provided. Instead the sub-beams 211, 212, 213 may be generated from the source beam at the objective lens array. The objective lens array may feature an upper beam limiter and a beam shaping limiter. In such an arrangement the source 201 provides a beam of charged particles (e.g. electrons). Sub-beams may be derived from the beam, for example, using a beam limiter defining an array of beam-limiting apertures, e.g. the upper beam limiter. The upper beam limiter defines an array of beam-limiting apertures and functions as a beam separator or sub-beam generator. The upper beam limiter may be located upbeam of the deflectors 235.

In some embodiments, exemplified in **FIG. 3**, the deflectors 235 are the first deflecting or focusing electron-optical array element in the beam path down-beam of the source 201. In another arrangement, a macro-collimator may be provided upbeam of the objective lens array. Thus the macro-collimator operates on the beam from the source before generation of the multi-beam. A magnetic lens may be used as the macro-collimator. When a macro-collimator is provided, the collimator deflectors 235 may be omitted.

In another arrangement, a macro scan deflector may be provided upbeam of the objective lens array. Thus the macro scan deflector operates on the beam from the source before generation of the multi-beam. The macro scan deflector may be downbeam of a macro-collimator. When a macro scan deflector is provided, the scan deflector array 260 may be omitted.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

As described above, multiple electron-optical components in an electron optical column (such as a multibeam SEM or multibeam lithographic machine) are typically required to create a plurality of beams. The electron-optical components form electron optical apertures, lenses, deflectors and perform other manipulations of the beams. These electron optical components may include elements having multiple apertures arranged in two dimensional arrays across the beam path. Such elements may be of a small dimension. The elements or indeed the corresponding apertures of the different elements need to be aligned accurately to allow all beams to land on a target (for example a sample or a detector). Elements which are in close proximity to each other can be stacked on top of each other and are relatively easy to align for example during manufacturing of the stack and during assembly of a charged particle device (e.g. electron-optical column). MEMS fabrication techniques are suitable for making the elements. The elements may be referred to as MEMS elements.

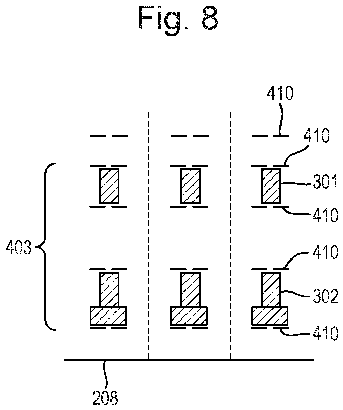

**FIG. 8** shows the detector elements of the detector array being associated with possible different locations in the objective lens array 403, and alternatively or additionally with another electrode of the objective lens array or an electrode (or plate) associated and proximate to the objective lens array. The detector array may additionally or alternatively be associated with such an electrode of the objective lens array or associated and proximate to the objective lens array. The detector array may be integrated into such a plate. In an arrangement additionally or alternatively the detector array is located upbeam of the objective lens array and any electron-optical element associated with the objective lens. The detector elements of the detector array may be associated with respective sub-beams. The detector elements may comprise charge detecting, electron to photon converters e.g. scintillators and semiconducting elements such as PIN detecting elements. In an arrangement the detector elements for example converters e.g. scintillators may be set to one side of the beam paths so that the beams towards the sample pass to the side of respective detector elements.

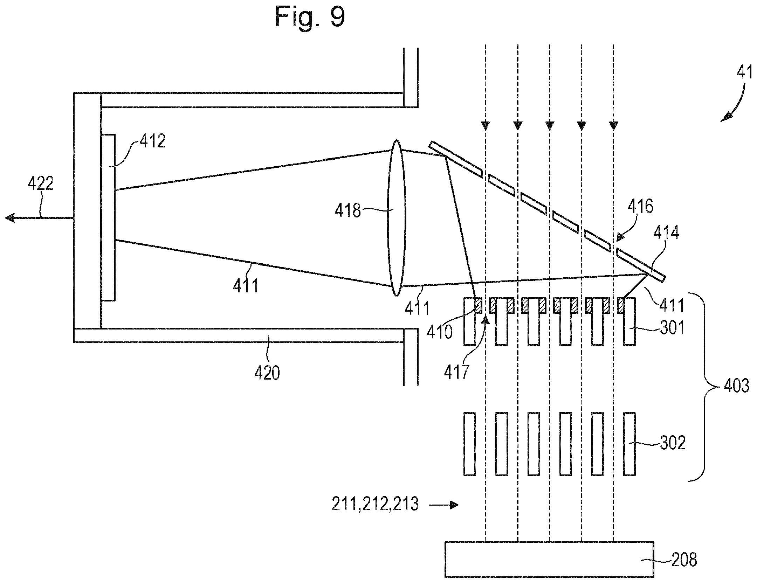

In **FIG. 8** vertical broken lines depict paths of two example beams through respective objective lenses of the objective lens array 403. Five example locations for the detector elements 405, 410 are shown; the detector element 405, 410 may be a converter 410 such as a scintillator (e.g. as shown in **FIG. 9**) or may be a capture electrode 405 (e.g. as shown in **FIG. 5**). The detector elements 405, 410 may be provided at a single one of these five example locations or at more than one location. Some of the locations are more favorable than others. The less favorable locations may be used in combination with other locations to capture sufficient signal. The detector elements 405, 410 may be provided below an electrode 302 of the objective lens array 403 that is closest to the sample 208 (e.g. facing the sample 208). The detector elements 405, 410 may be positioned above the electrode closest to the sample 208. The detector elements 405, 410 may be positioned below an electrode adjacent to the electrode closest to the sample 208. In this case, the detector elements 405, 410 may be positioned closer to, and/or attached to, the electrode closest to the sample 208. Alternatively, the detector elements 405, 410 may be closer to, and/or attached to, the adjacent electrode. Alternatively, the detector elements 405, 410 may be positioned above the adjacent electrode, either directly adjacent and/or attached to the adjacent electrode or separated from the adjacent electrode and/or positioned further away.

In an arrangement and considering an electron-optical design with any type of electron-optical element, each detector element 405, 410 such as a converter or capture electrode surrounds an aperture 417 configured to allow passage of a respective one of the plurality of beams. The aperture 417 may be defined in an electrode of the objective lens or in a separate aperture body. Each detector element in this arrangement is around the path of a respective beam. Each detector element 405, 410 may be positioned to receive signal electrons propagating generally along the path of the beam in an opposite direction to the beam. The signal electrons may thus impinge on the detector element 405, 410 in an annular region. Signal electrons do not impinge on the center region of the annulus because of the aperture for allowing passage of the corresponding primary beam in the opposite direction.

In some arrangements, each detector element 405, 410 comprises multiple portions. The different portions may be referred to as different zones. Such a detector element 405, 410 may be referred to as a zoned detector element. The portions of a detector element may surround the aperture defined in the detector element. Signal particles captured by the detector element portions may be combined into a single signal or used to generate independent signals.

The zoned detector element 405, 410 may be associated with one of the beams 211, 212, 213. Thus, the multiple portions of one detector element 405, 410 may be configured to detect signal particles emitted from the sample 208 in relation to one of the beams 211, 212, 213. The detector element comprising multiple portions may be associated with one of the apertures in at least one of the electrodes of the objective lens array. More specifically, the detector element 405, 410 comprising multiple portions may be arranged around a single aperture.

The portions of the zoned detector element may be separated in a variety of different ways, e.g. radially, annularly, or in any other appropriate way. Preferably the portions are of similar angular size and/or similar area and/or similar shape. The separated portions may be provided as a plurality of segments, a plurality of annular portions (e.g. a plurality of concentric annuli or rings), and/or a plurality of sector portions (i.e. radial portions or sectors). The detector element 405, 410 may be divided radially. For example, the detector element 405, 410 may be provided as annular portions comprising 2, 3, 4, or more portions. More specifically, the detector element 405, 410 may comprise an inner annular portion surrounding an aperture and an outer annular portion, radially outwards of the inner annular portion. Alternatively, the detector element 405, 410 may be divided angularly. For example, the scintillator 410 may be provided as sector portions comprising 2, 3, 4, or more portions, for example 8, 12 etc. If the detector element 405, 410 is provided as two sectors, each sector portion may be a semi-circle. If the detector element 405, 410 is provided as four sectors, each sector portion may be a quadrant. In an example, the detector element 405, 410 is divided into quadrants, i.e., four sector portions. Alternatively, the detector element 405, 410 may be provided with at least one segment portion.

Providing multiple portions concentrically or otherwise may be beneficial because different portions of the detector element 405, 410 may be used to detect different signal particles, which may be smaller angle signal particles and/or larger angle signal particles, or secondary signal particles and/or backscatter signal particles. Such a configuration of different signal particles may suit a concentrically zoned detector element. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

In an arrangement of a charged particle device with the detector array upbeam of the sample facing part or base of the charged particle device, for example upbeam of the objective lens array, it can be challenging to ensure that the signal particles generated on impact of a beam are detected by the respective detector element or detector elements arranged along the path of the beam towards the sample. One way of achieving this is to have a deflecting element between the detector array and the objective lens, such as a Wien filter e.g. a Wien filter array. Such a Wien filter permits sub-beams to pass through the Wien filter towards the sample undeflected but directs signal particles from the sample towards the respective detector elements. Detector elements such as converters 410, e.g. scintillators, may be positioned upbeam of the objective lens array. Optical converters to convert light generated by the converters into electronic signals may be associated with the respective detector elements. The optical converters may be coplanar and even in direct contact with the scintillating detector elements. Such optical converters are described in EP Application 21183803.2 filed on 5 July 2021, which filing is incorporated by reference at least with respect to the optical converters associated with the converters, e.g. scintillators, for converting signal particles into a light signal and the architecture and use of detectors for detecting signal particles.

**FIG. 9** depicts a different arrangement featuring detector elements upbeam of an objective lens array. A different arrangement is disclosed instead of a deflecting element such as a Wien filter and instead of a direct optical to electron signal converter to convert the optical signal from the scintillator elements into a processable signal. **FIG. 9** schematically depicts a scintillator-based detector approach that facilitates close packing of beams at the sample 208. For ease of depiction, **FIG. 9** depicts only a portion of an example electron optical device in the vicinity of an objective lens array 403 of the electron optical device and the sample 208. The electron optical device 41 may comprise an aperture array (to form the sub-beams of the multi-beam from the source beam) and a collimator upbeam of the region of the electron optical device shown in **FIG. 9**. The aperture array generates a plurality of beams. The collimator collimates paths of the beams. The detector in this example comprises a plurality of converters 410 and a light sensor 412. The converters 410 may be scintillators. The plurality of converters 410 may be referred to as a converter array. Broken line paths depict representative paths of the beams. The converters 410 receive signal particles emitted from the sample 208. The converters 410 generate light 411 in response to the received signal particles. The converters 410 may comprise luminescent material that absorbs energy from incoming particles and re-emits the absorbed energy as light. The light sensor 412 detects light 411 generated by the converters 410 and thereby indirectly detects the signal particles.

A light guiding arrangement is provided that reduces or avoids the need for optical fibers. The light guiding arrangement guides light 411 generated by the converters 410 to the light sensor 412. The light guiding arrangement comprises a mirror 414. Light 411 generated by the converters 410 is reflected by the mirror 414 towards the light sensor 412. (Thus, the mirror is an embodiment of a radiation reflective surface that is reflective of radiation having a wavelength corresponding to the scintillators). Optics 418 may be provided for controlling propagation of reflected light between the mirror 414 and the light sensor 412. The optics 418 may, for example, image the reflected light onto the light sensor 412. The arrangement allows the light sensor 412 to be positioned outside of the part of the column through which the beams pass (i.e. away from the beam arrangement), as indicated schematically in **FIG. 9** by the laterally protruding housing 420. The light sensor 412 may thus be provided at a radially distal position relative to the path of the beams. For example, a separation between a central longitudinal axis of the plurality of beams and a radially outermost one of the beams is smaller than a distance from the longitudinal axis to the light sensor 412. The light sensor 412 does not therefore restrict close packing of the beams. The light sensor 412 can furthermore be implemented easily because there are fewer space restrictions at the location of the light sensor 412 than there are closer to the longitudinal axis. Furthermore, the mirror redirects light without requiring optical fibers or the like, thereby further reducing restrictions to close packing of the beams. The light sensor 412 can be provided within a vacuum region or outside of a vacuum region e.g. with a window or other arrangement being provided to transport light from the mirror 414 (in a vacuum region) to the light sensor 412 (outside of the vacuum region).

The light sensor 412 may be implemented using any of various known devices for detecting light, such as a charge-coupled device (CCD) for example. In some arrangements, the light sensor 412 comprises a photodiode array. The light sensor 412 may be configured or selected to have a wavelength sensitivity matched to the scintillator spectrum (i.e. the wavelength spectrum of the photons emitted by the scintillator element). Appropriate data lines 422, of various known arrangements, may be provided for extracting data representing the detected light.

In some arrangements, the light guiding arrangement comprises one or more optical fibers between the mirror 414 and the light sensor 412. The optical fibers collect light from the mirror and guide the light to a location further away from the part of the column through which the beams pass, for example away from the path of the beam arrangement. Using optical fibers in this way provides further flexibility for positioning of the light sensor 412 (and associated electronics and/or data lines). (Such fibers may be applied to the arrangement of the Wien filter in which the fibers are positioned to be in optical communication with the converters (e.g. scintillator elements)).

In some arrangements, at least part of the light guiding arrangement and the objective lens array are structurally connected. A support for the mirror 414 may be structurally connected to and/or support at least a most proximate electrode of the objective lens array 403. For example, the support for the mirror 414 may be structurally connected to a support of the most proximate electrode.

To allow the plurality of beams to pass through the mirror 414, the mirror 414 is configured to define a plurality of apertures 416 through the mirror 414. The apertures 416 are positioned to allow passage of the plurality of beams through the mirror 414 towards the sample 208. Each aperture 416 may thus correspond to a respective one or more of the beams (i.e., be positioned to allow the respective one or more beams to pass through it).

In some arrangements, the converters 410 are each configured to receive signal particles originating from interaction between the sample 208 and a respective single one of the plurality of beams from the aperture array 401. Thus, for one position of the column relative to the sample 208, each converter 410 receives signal particles from a different portion of the sample 208.

In some arrangements, the converters are arranged in an array. The array is orthogonal to the path of the plurality of beams (i.e., substantially orthogonal to each of the paths). The array may comprise a two-dimensional pattern. The two-dimensional pattern may take the form of a grid. The arrangement may be a hexagonal or rectilinear grid. The array of converters may correspond geometrically to the array of beams 211, 212, 213. The converters may take the form of an annulus around an aperture for the path of a corresponding primary beam (or more than one primary beam). Thus, an aperture may be defined by each scintillator. Each converter element in the array of converters may have the form of an annulus.

In an arrangement, the converters 410 are positioned up-beam of at least one electrode 302 of the objective lens array 403 for example at any of the positions shown and described with reference to **FIG. 8**. As described above, **FIG. 8** shows example locations for the converters 410 relative to a portion of an example objective lens array 403. The converters 410 may be positioned upbeam of an electrode 302 facing the sample 208. In some arrangements, as exemplified in **FIG. 9**, the converters 410 are supported by one of the electrodes 301 of the objective lens array 403. In the example shown, the converters 410 are supported by an electrode 301 of the objective lens array 403 that is furthest from the sample 208. The converters 410 are at the same level as an uppermost portion (furthest from the sample 208) of the electrode 301. In some arrangements, the scintillators 410 are positioned up-beam of the objective lens array 403, for example directly up-beam thereof (e.g., a small distance therefrom and/or with no intervening elements between the converters 410 and the objective lens array 403).

As mentioned detector elements such as converters 410 may comprise multiple portions. Providing multiple portions concentrically or otherwise may be beneficial because different portions of the converter 410 may be used to detect different signal particles, which may be smaller angle signal particles and/or larger angle signal particles, or secondary signal particles and/or backscatter signal particles. Note the arrangement of **FIG. 9** may have limited ability to detect backscatter signal particles. For example, the arrangement may be limited to detect backscatter signal particles with a small-angle backscatter particles. That is, the backscatter signal particles that are detectable using this arrangement are limited by the relatively large distance between the sample 208 and the converter 410 and the relatively narrow paths from the sample 208 to respective converters 410 (for example because of the respective apertures through the electrode 302). In such an arrangement the converter is unlikely to have concentric portions because of the low angular range of backscatter signal particles that such a converter is capable of detecting. Note this limitation of application is relevant not just for converters but any type of detector element at such a position along the path of a beam towards the sample.

The converters 410 may be provided as converter elements each associated with one or more beams of the plurality of beams. Alternatively or additionally, the converters 410 may be provided as a monolithic converter in which a plurality of apertures are defined, each aperture corresponding to a respective one or more beams of the plurality of beams. In some arrangements, the converters are arranged in an array of strips. Each strip may correspond to a group of primary beams. The beams may comprise a plurality of rows of beams and each group may correspond to a respective row.

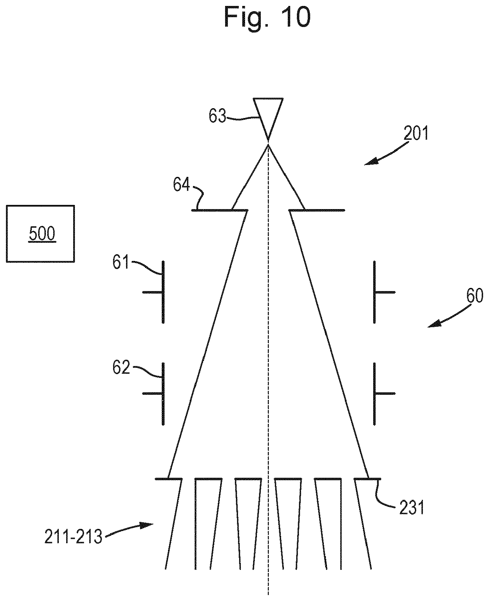

**FIG. 10** is a schematic diagram of an exemplary electron optical apparatus according to an embodiment. The electron-optical apparatus is configured to generate a plurality of sub-beams 211-213 from a source beam 202 of electrons. The electron-optical apparatus is configured to direct the sub-beams 211-213 downbeam toward a sample position (i.e. a position occupied by a sample 208). Note the number of beams should neither be limited by three references to the sub-beams nor by the number of sub-beams depicted.

The electron-optical apparatus is configured to project a multi-beam of electrons. The electron-optical apparatus comprises an electron device (also known as an electron optical device 41 or an electron optical column). The electron-optical apparatus may be arranged as described in any of the embodiments described above. The arrangement shown in **FIG. 10** may be provided as part of the arrangement shown in **FIG. 3** or any other suitable design of electron optical device. In other embodiments, the electron-optical apparatus is similar to another of the arrangements described above such as an arrangement comprising a macro collimator and a macro scan deflector instead of the collimator deflectors 235 and the scan deflector array 260. In other embodiments, the arrangement shown in **FIG. 10** may be provided as part of another of the arrangements described above such as an arrangement shown in **FIG. 9**.

As shown in **FIG. 10**, in an embodiment the electron optical device comprises an electron source 201. The electron source 201 is configured to output the source beam 202 of electrons. As shown in **FIG. 10**, in an embodiment the electron source 201 comprises an emitter 63. The emitter 63 is configured to emit the source beam 202 of electrons along a divergent path. The divergent shape of the divergent path is shown in **FIG. 10**. The cross-sectional area of the divergent path increase with increasing distance downbeam of the emitter 63.

As shown in **FIG. 10**, in an embodiment the electron source 201 comprises an extractor electrode 64. The extractor electrode 64 is downbeam of the emitter 63. The extractor electrode 64 may be applied with an electrical potential such that the extractor electrode 64 accelerates electrons away from the emitter 63. As shown in **FIG. 10**, in an embodiment the extractor electrode 64 comprises an aperture. That is the extractor electrode may be a plate in which the aperture is defined. The extractor electrode 64 comprising the aperture may filter out part of the source beam 202 from the emitter 63. For example, part of the source beam 202 may be blocked by the extractor electrode 64.

As shown in **FIG. 10**, in an embodiment the divergent path remains divergent downbeam of the extractor electrode. 64. The divergent path is divergent downbeam of the electron source 201. The source beam 202 may be uncollimated.

As shown in **FIG. 10**, in an embodiment the electron-optical device comprises an aperture array. Apertures 232 are defined in the aperture array. The aperture array is configured to generate sub-beams 211-213 from the source beam 202. The aperture array may be a beam generator. The aperture array may be comprised in the condenser lens array 231. Alternatively, the aperture array may be provided separately from the condenser lens array 231. The aperture array is positioned in the divergent path. As shown in **FIG. 10**, in an embodiment the divergent path remains divergent at the aperture array. The source beam 202 is divergent when it is incident on the aperture array. In an embodiment the electron-optical device comprises a plurality of aperture arrays between the aperture array and the sample 208. A plurality of apertures defined in each of the plurality of aperture arrays are for a corresponding path of the plurality of sub-beams 211-213. The paths of the sub-beams 211-213 may be divergent downbeam of the aperture array 231. In an arrangement a collimator may be downbeam of the aperture array to collimate the paths of the sub-beams for example with respect to each other,

As shown in **FIG. 10**, in an embodiment the electron-optical device comprises at least one electron-optical component 60. The at least one electron-optical component 60 is configured to act on the source beam 202 of electrons upbeam of the aperture array. In an embodiment the at least one electron-optical component 60 is configured to control one or more characteristics of the source beam 202. In an embodiment the at least one electron-optical component 60 is configured to control one or more characteristics of the source beam 202 incident on the aperture array.

As shown in **FIG. 10**, in an embodiment the electron-optical device comprises a controller 500. The controller 500 is configured to control the at least one electron-optical component 60 so as to control at least one property of the source beam 202 on the aperture array. In an embodiment the at least one property comprises at least one of divergence, uniformity of current, uniformity of divergence, uniformity of energy spread and uniformity of brightness. In an embodiment the controller 500 is configured to use measurements of the source beam 202 (e.g. a measurement providing information about the uniformity of the source beam 202) so as to control the source beam 202. In an embodiment the electron-optical component 60 is configured to steer, focus, shape and/or stigmate the source beam 202 between the electron source 201 and the beamlet generating aperture array. For example, in an embodiment the at least one electron-optical component 60 is configured to select the part of the overall source emission pattern (i.e. the part of the source beam 202) that gives the average beamlet performance above a predetermined threshold (or the best average beamlet performance). Additionally or alternatively the at least one electron-optical component 60 is configured to select the part of the source beam 202 that gives a distribution over the beamlets having a symmetry above a predetermined threshold (or the most symmetric distribution). An embodiment of the invention is expected to improve control of characteristics of the source beam 202.

The emission of the electron source 201 may not be perfectly uniform. For example, the brightness spread and/or the energy spread may increase with off-axis angle. To some degree this non-uniformity can be accepted, by specifying system performance for the performance of the worst beamlet, and accepting a better performance (e.g. more beamlet current) for other beamlets. An embodiment of the invention is expected to control the uniformity of the source beam 202.

In an embodiment the emitter 63, for example a Schottky emitter or a thermal emitter (which typically has lower brightness than a Schottky emitter), comprises a tip from which the electrons are emitted. The pattern of the emitted source beam 202 may change over time. For example, the tip may change shape due to growth of the tip and/or growth of a facet of the emitter 63 and/or shrinkage of the emitter 63. Any change on shape may result in a change in pattern of the source beam 202. An embodiment of the invention is expected to correct and/or compensate for changes in the shape of the emitter 63 over time.

Additionally or alternatively, the position and/or orientation of the tip can change over time, for example by thermal drift. These changes can result in changes in the source beam 202 over time, for example performance deviation between beamlets 211-213. These changes can also cause overall system performance deterioration. An embodiment of the invention is expected to correct and/or compensate for changes in the position and/or orientation of the emitter 63 of the electron source 201 over time.

In an embodiment the at least one electron-optical component 60 is configured to correct and/or compensate for changes in the source emission by correcting the overall source beam 202 from the source 201 upbeam of where the source beam 202 is split into beamlets 211-213. In an embodiment the at least one electron-optical component 60 comprises at least one macro electron-optical element. A macro electron-optical element is an electron-optical element that influences the whole beam envelope (rather than only part of the source beam 202 corresponding to one or more beamlets).

In an embodiment the at least one electron-optical component 60 comprises an electron-optical component configured to deflect the source beam 202 and/or an electron-optical component configured to focus the source beam 202 and/or an electron-optical component configured to shape the source beam 202. Possible components of the at least one electron-optical component 60 are described below in more detail.

In an embodiment the at least one electron-optical component 60 comprises at least one multipole configured to operate on the source beam 202 so as to vary the position of the divergent path at the aperture array and/or to vary a cross-sectional shape of the divergent path at the aperture array. For example, as shown in **FIG. 10**, in an embodiment the at least one electron-optical component 60 comprises a first multipole 61 and a second multipole 62. In an embodiment the first multipole 61 and the second multipole 62 are configured to operate on the source beam 202 so as to vary the position of the divergent path at the aperture array. In an embodiment at least one of the multipoles comprises a plurality of electrodes around the divergent path. In an embodiment the first multipole 61 and the second multipole 62 form deflectors configured to deflect the source beam in one or more directions perpendicular to the electron-optical axis. In an embodiment the first multipole 61 and the second multipole 62 form macro deflectors configured to steer the source beam 202 between the electron source 201 and the aperture array. Desirably both the first multipole 61 and the second multipole 62 are present so that the beam is steerable with the desirably optimum number of degrees of freedom. At least one of the multipoles may comprise a plurality of electrodes configured to be operated at independently controllable potentials so as to form a deflector. In an arrangement at least one of the multipoles may be magnetic comprising a plurality of coils and/or magnetic poles configured to be operable at independently controllable currents to form a deflector.

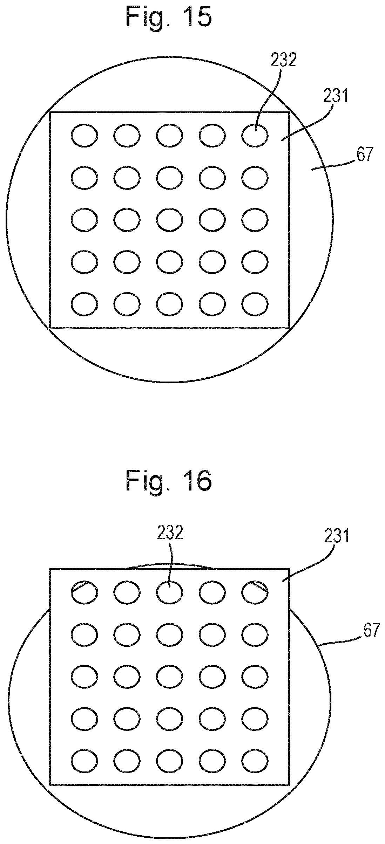

**FIG. 15** shows a preferred portion 67 of the source beam at the aperture array. In an embodiment the controller 500 is configured to control the at least one electron-optical component 60 so as to control a preferred portion 67 of the source beam 202 to cover the apertures 232 of the aperture array. As shown in **FIG. 15**, in an embodiment all of the apertures 232 are covered by the preferred portion 67 of the source beam 202. The preferred portion may be a portion that is large enough to cover the apertures 232 while satisfying a preferred characteristic. For example, the preferred portion 67 may be more uniform and/or increase (or maximize) the performance (e.g. brightness, current) of the worst performing sub-beam. In an embodiment the preferred portion 67 of the source beam 202 is determined based on information about the source beam 202 and/or the sub-beams 211-213. For example, characteristics of different parts of the source beam 202 may be monitored so as to determine the preferred portion 67 to meet predetermined characteristics.

In an embodiment the preferred portion 67 of the source beam 202 is determined based on information about the source beam 202 and/or the sub-beams 211-213. For example, measurements of the source beam 202 and/or the sub-beams 211-213 may be made. The measurements may provide information such as the level of brightness and/or the current of different parts of the source beam 202 and/or different sub-beams 211-213. In an embodiment the controller 500 is configured to control the at least one electron-optical component based on the measurements. In an embodiment the electron-optical device comprises a detector 240, for example as described above with reference to **FIGs. 3-9**. In an embodiment the detector 240 is configured to generate the measurement signal.

In an embodiment the detector is a detector array configured to detect signal particles generated by the sub-beams on a sample 208. The detector array may face the sample position. Such an arrangement is shown in **FIGs. 3-7**, for example. Additionally or alternatively, the detector is a sensor system configured to a detect at least part of the source beam 202 and/or sub-beams 211-213 such as one or more sub-beams along the path of the sub-beams between the aperture array and the sample position, for example on an electron-optical component such as the aperture array. The electron-optical apparatus may comprise a sample support 207 for supporting the sample 208. The sample support 207 may comprise at least part of the sensor system.

In an embodiment the controller 500 is configured to control the at least one electron-optical component 60 so as to compensate for change in the divergent path between the emitter 63 and the aperture array. The change in the divergent path may comprise at least one of: movement of the source beam 202 relative to the aperture array, change in a shape of the emitter 63, and/or change in emission distribution. The movement of the source beam 202 may correspond to a shift in the position of the emitter 63 relative to the aperture array and/or a tilt of the emitter 63 relative to the aperture array

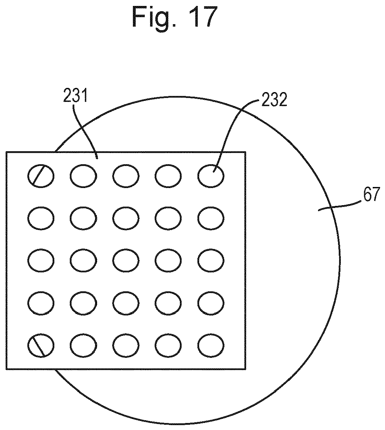

As shown from a comparison between **FIG. 15** and **FIG. 17**, in an embodiment the source beam 202 is steered by one or more macro deflectors. The macro deflectors may be provided at at least two positions along the electron-optical axis. In an embodiment the one or more macro deflectors are configured to correct and/or compensate for a shift and/or a tilt of the tip of the emitter 63. An embodiment of the invention is expected to reduce and/or eliminate changes in the pattern of the source beam 202 over time. Desirably at least two macro deflectors are present in the electron optical component to correct or at least compensate for both shift and tilt.

In an embodiment the source beam 202 from the electron source 201 is larger (in cross-section) than what is nominally needed to cover all of the apertures 232 of the aperture array. This allows a preferred portion 67 of the source beam 202 that is more uniform or symmetric, for example, to be selected while covering all of the apertures 232. The steering and/or focusing may not cause the beam to fail to cover all of the apertures 232.

In an embodiment the size of the aperture in the extractor electrode 64 is selected so as to control the size of the overall source beam 202. An increased aperture size corresponds to an increased cross-sectional area for the source beam 202. An increased cross-sectional area for the source beam 202 facilitates selecting the preferred portion 67. A decreased aperture size corresponds to a decreased beam current between the extractor electrode 64 and the aperture array. A decreased beam current corresponds to fewer Coulomb interactions and improved brightness of the source beam 202. The size of the aperture in the extractor electrode 64 may be selected so as to provide a compromise between having a good correction range for steering and focusing and having good brightness.

As mentioned above, in an embodiment the at least one electron-optical component 60 comprises at least one multipole configured to operate on the source beam 202 so as to vary a cross-sectional shape of the divergent path at the aperture array. For example, the at least one electron-optical component 60 may comprise at least one multipole configured to form a stigmator. The stigmator may be used to correct and/or compensate for any non-rotational symmetry in the overall source beam 202. Such non-rotational symmetry may be caused by, for example, asymmetric growth of facets on the tip of the emitter 63. The stigmator may be electrostatic. In an embodiment the stigmator is formed by using a plurality of (e.g. at least eight) segments (e.g. radial segments) in one or both of the first multipole 61 and the second multipole 62. In a multipole with more than eight segments such as twelve or more segments, the stigmator has an additional number of segments (which may each provide an additional degree of freedom) that enables improved control of the shape the cross-section of the divergent beam. Each multipole may be electrostatic or magnetic. Each segment having an electrostatic function may have an individually controllable potential. Each segment may be an electrode of an electrostatic multipole. Each segment having an electromagnetic function may have an individually controllable current. Each segment may correspond to a coil and/or pole of a plurality of coils and/or poles. Each segment may be a coil and/or magnetic pole of an electromagnetic multipole. In an embodiment the first multipole 61 and/or the second multipole 62 is configured to function as both a deflector and a stigmator.

**FIG. 16** shows a preferred portion 67 of the source beam 202 at the aperture array. In an embodiment the controller 500 is configured to control the at least one electron-optical component 60 so as to control the preferred portion 67 of the source beam 202 to cover all of the apertures 232 of the aperture array. As shown in **FIG. 16**, the shape of the source beam 202 may be non-circular, for example elliptical. It may be desirable for the preferred portion to be circular. The stigmator may be configured to control the shape of the cross-section of the source beam 202 at the aperture array. In an embodiment the stigmator is configured to control the cross-section of the source beam 202 at the aperture array to be circular.

In an embodiment the at least one electron-optical component 60 comprises an electron-optical lens. The electron-optical lens is configured to compensate for variations in distance between the emitter 63 and the aperture array. In an embodiment the electron-optical lens is a focusing lens. To correct or at least compensate for such variations the lens may be weak, or 'weakly focusing'. The electron-optical lens may be configured to control the divergence of the source beam 202 at the aperture array. As a focusing lens, the correction of a variation in distance can only correct for increases in the distance with time. By having the focusing lens (for example the weakly focusing lens) continually operating on the divergent beam path from the start of the source emission (that is to be set with a focusing strength from the start of operating), corrections for increments and reductions in the distance with time may be achieved by increasing or decreasing the focusing strength of the lens. The source beam 202 is not in focus at the aperture array. The sub-beams 211-213 are focused on the sample 208 by, for example, the objective lens array downbeam of the aperture array. By varying the divergence, it is possible to control the coverage of the apertures 232. In an embodiment the electron-optical lens is configured to vary an angle of divergence of the source beam 202. In an embodiment the electron-optical lens is configured to vary a proportion of coverage of the aperture array by the source beam 202. For example, the electron-optical lens may be configured to control the source beam 202 such that all of the apertures 232 of the aperture array are covered by the source beam 202. Alternatively the electron-optical lens may be configured to control the source beam 202 such that a subset of the apertures 232 are covered by the source beam 202. The electron-optical lens may be configured to correct and/or compensate for the possible shift of the source 201 along the electron-optical axis (e.g. by tip growth along the electron-optical axis).

In an embodiment the electron-optical lens is electrostatic. In an embodiment the first multipole 61 and the second multipole 62 are electrostatic. In a different embodiment at least one of the first multipole 61 and the second multipole 62 is electromagnetic. This applies even if one or both of the multipoles is electromagnetic rather than being electrostatic. That is an electromagnetic multipole may have an electrostatic function with respect to the other multipole. In an embodiment the electron-optical lens is formed by having one or both of the first multipole 61 and the second multipole 62 at a different potential than the other of the first multipole 61 and the second multipole 62 and the extractor electrode 64 or the aperture array. The electron-optical lens may be formed by the facing surfaces in between the first multipole 61 and the second multipole 62; that is between a downbeam facing surface of the first multipole 61 and an upbeam facing surface of the second multipole 62. In an embodiment the electron-optical lens is formed by having the first multipole 61 and the second multipole 62 or at least their mutually facing surfaces at different potentials. In an embodiment the first multipole 61 and/or the second multipole 62 is configured to function as both a deflector and part of an electron-optical lens. In an embodiment the first multipole 61 and/or the second multipole 62 is configured to function as each of a deflector, a stigmator and part of an electron-optical lens.

The strength of the electron-optical lens required to correct and/or compensate for the possible shift of the emitter 63 along the electron-optical axis depends on the extent of the shift. If there is not much tip change in the direction of the electron-optical axis, then only a weak electron-optical lens may be required.

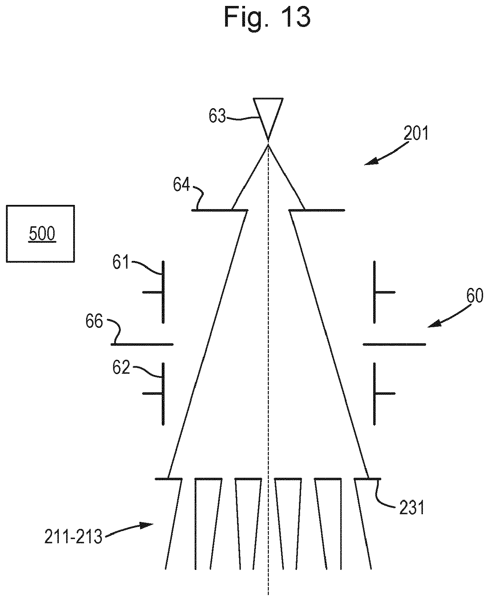

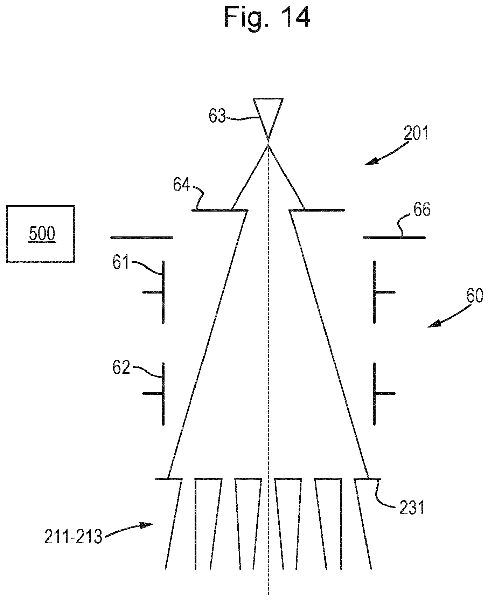

Additionally or alternatively, the electron-optical device may comprise an electrode above, between or below the two multipoles to act as an electrostatic electron-optical lens. This is shown in **FIG. 13** and **FIG. 14**, for example. In an arrangement both of the electrodes as depicted in **FIG. 13** and **FIG. 14** may be present as described later in the description. In an arrangement each of the depicted electrodes 66 may be representative of multiple separate electrostatic electrodes. Such electrodes provide additional lensing functionality, desirably each additional electrode providing an additional degree of freedom, but also introducing additional complexity.

As shown in **FIG. 10**, for example, the at least one electron-optical component 60 for correcting changes in the source emission distribution is located downbeam of the extractor electrode 64. The at least one electron-optical component 60 has substantially no effect on the electric field distribution between the emitter 63 (e.g. cathode) and the extractor electrode (e.g. anode) of the electron source 201. The extraction voltage at the tip of the emitter 63 may be kept as constant as possible. The source emission may be kept stable.

In an embodiment one or more non-conducting surfaces may be provided between the segments of each multipole. By locating the at least one electron-optical component 60 downbeam of the electron source 201 which comprises the extractor 64, the possibility of such non-conducting surfaces charging up is reduced. The extractor reduces the cross-section of the source beam (or beam cone at least as far downbeam as the extractor). The extractor therefore reduces the number of electrons in the source beam and confines the source beam. Therefore locating the electron-optical component 60 downbeam of the emitter, fewer electrons are present in a more confined beam path. The risk of undesirably charging up non-conducting surfaces is reduced.

As shown in **FIG. 10**, for example, the at least one electron-optical component 60 for correcting changes in the source emission distribution is located upbeam of the aperture array. The at least one electron-optical component 60 is configured to act on the whole of the source beam 202 upbeam of where it is split into sub-beams 211-213. The at least one electron-optical component 60 may comprise macro electron-optical elements.

In an embodiment the at least one electron-optical component 60 comprises one or more of a deflector, a stigmator and an electron-optical lens. In an embodiment the at least one electron-optical component 60 comprises at least one electrostatic component. For example, in an embodiment the at least one electron-optical component 60 comprises at least one electrostatic deflector, an electrostatic stigmator and/or an electrostatic electron-optical lens. Electrostatic components are expected to be more compact than magnetic components.

In an embodiment the at least one electron-optical component 60 comprises at least two facing surfaces for the compensation of variations in distance between the emitter 63 and the aperture array. In an embodiment the at least one electron-optical component 60 comprises an electrostatic element configured to operate on the path of the divergent beam between the at least two facing surfaces. Optionally, the electrostatic element comprises a planar electrode and/or comprises a coil around the divergent beam path. For example, the electrostatic element may comprise part of a lens. In an embodiment the at least one electron-optical component 60 comprises two facing surfaces around the divergent beam path configured to operate as an electron-optical lens. In an embodiment at least one of the two facing surfaces is of a plate in which is defined an aperture for the divergent path. In an embodiment at least one multipole is downbeam of at least one of the facing surfaces. In an embodiment at least one multipole is upbeam of the two facing surfaces. In an embodiment the two facing surfaces are between two multipoles along the divergent path. In an embodiment at least one of the two facing surfaces is provided by a surface of at least one of the multipoles facing in the direction towards or away from the sample position.

In an embodiment the at least one electron-optical component 60 comprises at least one electrode associated with the aperture array. For example in the arrangement shown in FIG. 10, the first multipole 61 and the second multipole 62 may be associated with the condenser lens array 231. Alternatively, the second multipole 62 may be associated with the condenser lens array 231 and the first multipole 61 may be separate and distanced from the condenser lens array 231. The electrode associated with the aperture array may be provided by a facing surface of a multipole that faces the aperture array, such as the second multipole 62. Additionally or alternatively the electrode may be a plate located between the facing surface of the most proximate multipole in an upbeam direction. The electrode may electrostatically interact with the facing surface of the adjoining multipole. The electrode may be provided as a macro electrode with a single aperture for the path of the divergent beam towards the aperture array. With the aperture array the electrode, or electrodes, may operate as a lens array. One or more of the electron-optical components 60, such as the electrodes may be made with MEMS technology. In an embodiment one or more of the electron-optical components 60 is part of a stack of electron-optical components which may comprise the aperture array. If one or more of the electron-optical components is made using MEMS technology, the stack may be referred to as a MEMS stack.

In an alternative embodiment the at least one electron-optical component 60 comprises at least one electrode associated with the extractor electrode 64. For example in the arrangement shown in **FIG. 10**, the first multipole 61 and the second multipole 62 may be associated with the extractor electrode 64. Alternatively, the first multipole 61 may be associated with the extractor electrode 64 and the second multipole 62 may be separate and distanced from the extractor electrode 64. In an arrangement an additional electrode may be located between the extractor 64 and the first multipole 61. Together, the extractor electrode 64, the first multipole 61, optionally the second multipole and optionally an additional electrode in between the extractor 64 and the first multipole 61 may function as a lens. In an embodiment one or more of the electron-optical components 60 is part of a stack of electron-optical components which may comprise the extractor electrode 64. If one or more of the electron-optical components is made using MEMS technology, the stack may be referred to as a MEMS stack MEMS stack,

As mentioned above, in an embodiment the at least one electron-optical component 60 comprises at least one electrostatic component. Additionally or alternatively, in an embodiment the at least one electron-optical component 60 comprises at least one magnetic component. For example, the at least one electron-optical component 60 may comprise at least one magnetic deflector, at least one magnetic stigmator and/or at least one magnetic electron-optical lens.

In an embodiment the first multipole 61 and/or the second multipole 62 is magnetic. Each magnetic multipole may be configured as a magnetic deflector and/or a magnetic stigmator. In an embodiment the facing surfaces of the magnetic multipoles are configured as electrostatic surfaces forming an electron-optical lens.

In an embodiment the electron-optical device 41 comprises a magnetic macro deflector (not shown). The magnetic macro deflector is configured to select the preferred portion 67 of the source beam 202. The magnetic macro deflector may be provided in addition to the at least one electron-optical component 60. The magnetic macro deflector may be located outside the source vacuum module. The magnetic macro deflector is configured to deflect the source beam 202 between the emitter 63 and the extractor electrode 64. Due to the extension of the magnetic field the magnetic macro deflector may deflect the source beam 202 downbeam of the extractor electrode 64. In an embodiment the electron-optical device comprises magnetic shielding around the extractor electrode 64. The magnetic shielding may influence, for example reduce, the effect of the magnetic macro deflector on the source beam 202 downbeam of the extractor electrode 64. Additionally or alternatively, in an embodiment the at least one electron-optical component 60 (e.g. deflectors formed by the first multipole 61 and/or the second multipole 62) is configured to correct for any deflection of the source beam 202 downbeam of the extractor electrode 64 by the magnetic macro deflector. In an embodiment the at least one electron-optical component 60 is configured to keep the overall source beam on the electron-optical axis.

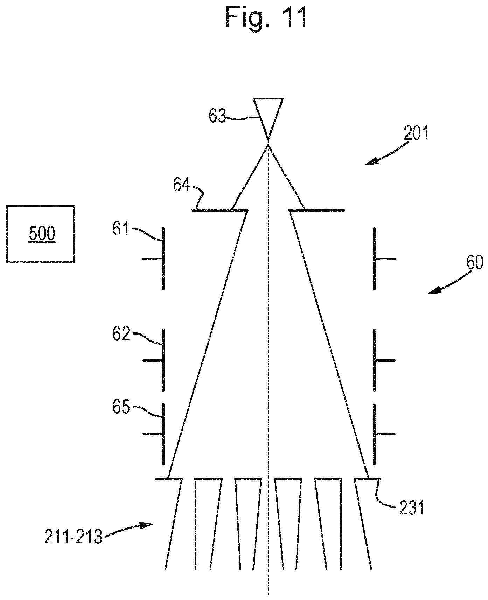

**FIG. 11** schematically shows an electron-optical device according to an embodiment of the invention. As mentioned above, in an embodiment a stigmator may be formed by the first multipole 61 and/or the second multipole 62, which may also function as deflectors. In an embodiment at least one multipole configured to operate as a deflector is different from at least one multipole configured to operate as a stigmator. Such an arrangement may be desirable when it is desirable to have more, for example many more, poles such as electrodes for the stigmator than is required by deflectors to achieve a uniform field. Such an application may be when the stigmator is used to achieve shaping of the cross-section of the divergent beam. Such beam shaping is a functionality more than the simplest stigmation. As shown in **FIG. 11**, in an embodiment the at least one electron-optical component 60 comprises a third multipole 65. The position of the third multipole 65 is shown most downbeam in the depicted embodiment. However, in other arrangements the third electrode may take another position such as the most upbeam or a position between the first multipole 61 and the second multipole 62. In an embodiment the third multipole 65 is configured to form a stigmator. For example the third multipole may comprise at least eight segments. The potential applied to each segment may be independently controllable. The stigmator may be configured to control the shape of the source beam 202 on the aperture array.

In an embodiment the first multipole 61 and the second multipole 62 are configured as deflectors. The third multipole 65 is configured as a stigmator. The first multipole 61 and the second multipole 62 may not be required to form a stigmator. Alternatively, the first multipole 61 and/or the second multipole 62 may form part of a stigmator in addition to the stigmator formed by the third multipole 65.

In an embodiment an electron-optical lens is formed by having one or more of the first multipole 61, the second multipole 62 and the third multipole 65 at a different potential than the other multipoles and the extractor electrode 64 or the aperture array.

Optional features of the first multipole 61 and the second multipole 62 described above may apply to the third multipole 65. For example, the third multipole 65 may be part of a stack of electrostatic elements with other components such as together with the condenser lens array 231. If one or more of the electrostatic elements is made using MEMS fabrication techniques, the stack may be referred to as a MEMS stack.

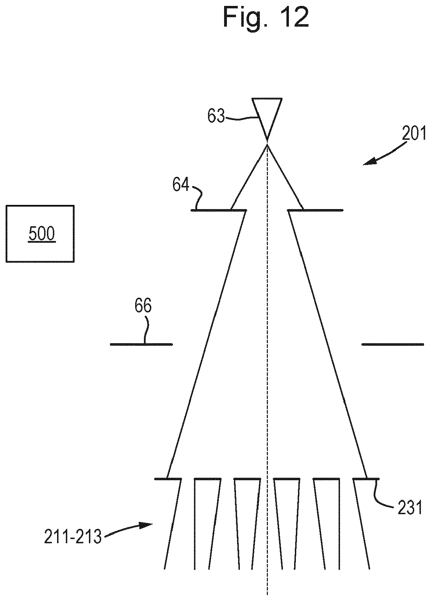

**FIG. 12** schematically shows an electron-optical device according to an embodiment of the invention. As shown in **FIG. 12**, in an embodiment the at least one electron-optical component 60 comprises a macro electron-optical lens 66. The macro electron-optical lens 66 is configured to compensate for variations in distance between the emitter 63 and the aperture array. The macro electron-optical lens 66 may have features as described above for the electron-optical lens with reference to **FIG. 10**.

As shown in **FIG. 12**, in an embodiment at least one electron-optical component 60 does not comprise any multipole. The macro electron-optical lens 66 may be the only electron-optical component between the electron source 201 and the aperture array.

In an embodiment the macro electron-optical lens 66 is electrostatic. The macro electron-optical lens 66 may comprise one or more electrodes (for example one or more plates). In an embodiment an macro electron-optical lens 66 is formed by having one or more electrodes at a different potential than one or more other electrodes, the extractor electrode 64 and/or the aperture array.

In an alternative embodiment the macro electron-optical lens 66 is magnetic. The macro electron-optical lens 66 may be located outside of the vacuum module. The macro electron-optical lens 66 may comprise a coil having multiple turns.

**FIG. 13** schematically shows an electron-optical device according to an embodiment of the invention. As shown in **FIG. 13**, in an embodiment the at least one electron-optical component 60 comprises a macro electron-optical lens 66 in addition to the first multipole 61 and the second multipole 62. The macro electron-optical lens 66 may have features as described above at least with reference to **FIG. 12**.

The first multipole 61 and the second multipole 62 may be configured as deflectors. In an embodiment the first multipole 61 and/or the second multipole 62 may be configured as part of a stigmator, as described above.

As shown in **FIG. 13**, in an embodiment the macro electron-optical lens 66 is located between the first multipole 61 and the second multipole 62 along the divergent path. The macro electron-optical lens 66 is located downbeam of the first multipole 61 and upbeam of the second multipole 62.

**FIG. 14** schematically shows an electron-optical device according to an embodiment of the invention. As shown in **FIG. 14**, in an embodiment the at least one electron-optical component 60 comprises a macro electron-optical lens 66 in addition to the first multipole 61 and the second multipole 62. The macro electron-optical lens 66 may have features as described above with reference to **FIG. 12**.

The first multipole 61 and the second multipole 62 may be configured as deflectors. In an embodiment the first multipole 61 and/or the second multipole 62 may be configured as part of a stigmator, as described above.

As shown in **FIG. 14**, in an embodiment the macro electron-optical lens 66 is located upbeam of the first multipole 61 and the second multipole 62. In an alternative embodiment the macro electron-optical lens 66 is located downbeam of the first multipole 61 and the second multipole 62.

In an embodiment there is a method of controlling a divergent path of an electron beam over an aperture array for generating a plurality of sub-beams 211-213 toward a sample position in an electron-optical apparatus. The method comprises emitting a beam of charged particles along a divergent path. The method comprises operating on the divergent path upbeam of an aperture array in which are defined a plurality of apertures, each aperture corresponding to a generated sub-beam. The method comprises generating sub-beams from the divergent beam at the aperture array. The operating on the divergent path comprises at least one of varying a position of the divergent path at the beam generator, compensating variations in distance between the emitter and the aperture array, and varying a shape of the divergent beam at the aperture array.

In an embodiment the method comprises controlling the operating on the divergent path based on information of the electron beam. In an embodiment the information of the electron beam comprises information of one more of the sub-beams. In an embodiment the method comprises detecting the beam so as to obtain the information of the electron beam. In an embodiment the information relates to one more of the position of the divergent path at the beam generator, distance between the emitter and the aperture array, and the shape of the divergent beam for example at the aperture array. In an embodiment the information relates to one more parameters such as the profile and/or the current, of one more sub-beams.

An electron-optical apparatus according to an embodiment of the invention may be an apparatus which makes a qualitative assessment of a sample (e.g. pass/fail), one which makes a quantitative measurement (e.g. the size of a feature) of a sample or one which generates an image of map of a sample. Examples of electron-optical apparatuses are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron optical device 41 (which may comprise an electron optical column) may be a component of an assessment tool, such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

A multi-beam electron-optical apparatus may comprise a gun aperture plate or Coulomb aperture array (not shown). The gun aperture plate is a plate in which apertures are defined. It is located in an electron-optical device downbeam of the source and before any other electron-optical device. In **FIG. 3** it would be located between the source 201 and the condenser lens array 231, for example upbeam, downbeam or integrated into the electron-optical component 60. Thus the gun aperture plate may be upbeam of, downbeam of, or in between, the first multipole 61 and the second multipole 62 The gun aperture plate, in operation, is configured to block off peripheral electrons of the source beam 202 to reduce Coulomb effects in the beam before the beam separator, for example in or associated with the condenser lens array. However, the gun aperture array may have fewer apertures than the condenser lens array and a number of apertures fewer than the number of beamlets that are down beam in the multi-beam. As a gun aperture array is a type of aperture array and is spaced apart from other beam limiting aperture arrays, such as the condenser lens array and the objective lens array, it may be considered in the alignment procedure too. Such a gun aperture plate may be suited for an electron-optical device for directing a plurality of electron beams towards the sample. The electron-optical device may comprise a macro condenser lens and a macro objective lens each of which may be magnetic. Between the two macro lenses is an aperture plate with associated array electron-optics comprising a plurality of arrays arranged along the paths of the beams. The array electron-optics may be provided in a MEMS stack. Upbeam of the objective lens is a defection arrangement such as a Wien filter to direct secondary electrons generated in response to the plurality of electron beams incident on a sample 208. A detector for detecting the signal particles may be in a second electron-optical device connected.

A multi-beam electron-optical apparatus may comprise a plurality of electron-optical devices (or columns). The multi-beam electron-optical apparatus may be a multi-device (or multi-column) apparatus. The multi-device apparatus may comprise multiple devices each configured to project a plurality of sub-beams of electrons towards a sample position. The multi-device apparatus comprises an electron-optical apparatus as described above comprising a plurality of the sources 201 and a plurality of corresponding electron-optical devices. Each electron-optical device comprises the aperture array and the at least one electron-optical component 60.

The multi-device apparatus may comprises a controller 500 configured to control the at least one electron-optical component 60 of the plurality of electron-optical devices to control a parameter of the plurality of the beams at the corresponding aperture arrays. The parameter may be the source beam uniformity, preferably at the corresponding aperture arrays, so as to control the source beam uniformity across the plurality of sources 201.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to up and low, upper and lower, lowest, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

References to elements being aligned along a beam path or sub-beam path are understood to mean that the respective elements are positioned along the beam path or sub-beam path.

Reference to a component or system of components or elements being controllable to manipulate or operate on a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 234, the condenser lens 231, correctors, and scan deflector array 260, under the control of the controller or control system or control unit. An actuatable component, such as a stage, may be controllable to actuate and thus move relative to another components such as the beam path using one or more controllers, control systems, or control units to control the actuation of the component.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on the charged particle beam emitted from the sample 208 in response to the charged particle beam.

Any element or collection of elements may be replaceable or field replaceable within the electron optical apparatus 40. The one or more charged particle-optical components in the electron optical apparatus 40, especially those that operate on sub-beams or generate sub-beams, such as aperture arrays and manipulator arrays may comprise one or more MEMS elements for example a MEMS stack.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses. Clause 1: A charged-particle apparatus configured to generate a plurality of sub-beams from a source beam of charged particles and direct the sub-beams downbeam toward a sample position, the charged-particle apparatus comprising; a charged-particle source comprising an emitter configured to emit a source beam of charged particles along a divergent path; an aperture array in which are defined apertures and positioned in the divergent path, the aperture array configured to generate sub-beams from the source beam; and at least one charged-particle-optical component configured to act on the source beam of charged particles upbeam of the aperture array; wherein the at least one charged-particle-optical component comprises: at least one multipole configured to operate on the source beam so as to vary the position of the divergent path at the aperture array and/or to vary a cross-sectional shape of the divergent path at the aperture array, and/or a charged-particle-optical lens configured to compensate for variations in distance between the emitter and the aperture array.

Clause 2: The charged-particle apparatus of clause 1, comprising: a controller configured to control the at least one charged-particle-optical component so as to control at least one property of the source beam on the aperture array.

Clause 3: The charged-particle apparatus of clause 2, wherein the at least one property comprises at least one of divergence, uniformity of current, uniformity of brightness, and uniformity of divergence.

Clause 4: The charged-particle apparatus of clause 2 or 3, wherein the controller is configured to control the at least one charged-particle-optical component based on a measurement signal containing information about the source beam and/or the sub-beams.

Clause 5: The charged-particle apparatus of clause 4, comprising a detector configured to monitor the source beam and/or the sub-beams.

Clause 6: The charged-particle apparatus of clause 5, wherein the detector is configured to generate the measurement signal.

Clause 7: The charged-particle apparatus of clause 5 or 6, wherein the detector is at least one of: a detector array configured to detect signal particles generated by the sub-beams on a sample, the detector array desirably facing the sample position; and/or a sensor system configured to detect at least part of the source beam and/or of one or more sub-beams such as one or more sub-beams along the path of the sub-beams between the aperture array and the sample position for example on a charged-particle-optical component between the aperture array and the sample position such as the aperture array, additionally or alternatively the apparatus comprising a sample support for supporting a sample, preferably the sample support comprising at least part of the sensor system.

Clause 8: The charged-particle apparatus of any of clauses 2 to 7, wherein the controller is configured to control the at least one charged-particle-optical component so as to control a preferred portion of the source beam to cover the apertures of the aperture array.

Clause 9: The charged-particle apparatus of clause 8, wherein the preferred portion of the source beam is determined based on information about the source beam and/or the sub-beams.

Clause 10: The charged-particle apparatus of any of clauses 2 to 9, wherein the controller is configured to control the at least one charged-particle-optical component so as to compensate for change in the divergent path between the emitter and the aperture array, the change in the divergent path comprising at least one of: movement of the source beam relative to the aperture array, change in a shape of the emitter, and/or change in emission distribution.

Clause 11: The charged-particle apparatus of clause 10, wherein the movement of the source beam corresponds to a shift in the position of the emitter relative to the aperture array and/or a tilt of the emitter relative to the aperture array.

Clause 12: The charged-particle apparatus of any preceding clause, wherein the at least one charged-particle-optical component comprises a charged-particle-optical lens configured to vary an angle of divergence of the source beam and/or a proportion of coverage of the aperture array by the source beam.

Clause 13: The charged-particle apparatus of any preceding clause, wherein the at least one charged-particle-optical component comprises a stigmator configured to vary a shape of the source beam on the aperture array.

Clause 14: The charged-particle apparatus of any preceding clause, wherein the charged-particle source comprises an extractor electrode downbeam of the emitter.

Clause 15: The charged-particle apparatus of clause 14, wherein the at least one charged-particle-optical component is downbeam of the extractor electrode.

Clause 16: The charged-particle apparatus of any preceding clause, wherein the at least one charged-particle-optical component comprises at least one electrostatic component.

Clause 17: The charged-particle apparatus of clause 16, wherein one of the multipoles is configured to be operated at a different potential from at least one of the other multipoles and the aperture array so as to form the charged-particle-optical lens.

Clause 18: The charged-particle apparatus of clause 16 or 17, wherein at least one of the multipoles comprises a plurality of electrodes configured to be operated at independently controllable potentials so as to form a stigmator.

Clause 19: The charged-particle apparatus of any of clauses 16 to 18, wherein at least one of the multipoles comprises a plurality of electrodes configured to be operated at independently controllable potentials so as to form a deflector.

Clause 20: The charged-particle apparatus of any preceding clause, wherein the at least one charged-particle-optical component comprises at least one electromagnetic component.

Clause 21: The charged-particle apparatus of any preceding clause, wherein the at least one charged-particle-optical component comprises at least one electrode associated with the aperture array.

Clause 22: The charged-particle apparatus of any preceding clause, comprising a plurality of aperture arrays between the aperture array and the sample, a plurality of apertures defined in each of the plurality of aperture arrays for a corresponding path of the plurality of sub-beams.

Clause 23: The charged-particle apparatus of any preceding clause, wherein the at least one charged-particle-optical component comprises at least one magnetic component.

Clause 24: The charged-particle apparatus of clause 23, wherein at least one of the magnetic multipoles is configured to have the function of a stigmator and/or deflector.

Clause 25: The charged-particle apparatus of clause 23 or 24, wherein at least one of the multipoles comprises a plurality of coils and/or magnetic poles configured to be operated at independently controllable currents so as to form a stigmator and/or deflector.

Clause 26: The charged-particle apparatus of any preceding clause, wherein the or each multipole comprises a plurality of electrodes and/or a plurality of coils and/or magnetic poles around the divergent path.

Clause 27: A charged-particle apparatus configured to generate a plurality of sub-beams from a divergent beam of charged particles and direct the sub-beams downbeam toward a sample position, the charged-particle apparatus comprising; a charged-particle source comprising an emitter configured to emit a beam of charged particles along a divergent path; an aperture array in which are defined apertures and positioned in the divergent path, the aperture array configured to generate sub-beams from the beam along the divergent path; and at least one charged-particle-optical component configured to act on the beam of charged particles upbeam of the aperture array; wherein the at least one charged-particle-optical component is configured to operate on the divergent path of the beam so as to vary the position of the divergent path at the aperture array, to vary a cross-sectional shape of the path of the charged particle beam at the aperture array, and/or to compensate for variations in distance between the emitter and the aperture array.

Clause 28: The charged-particle apparatus of clause 27, wherein the at least one charged-particle-optical component comprises at least one multipole for operating on the divergent path of the beam so as to vary the position of the divergent path at the aperture array and/or to vary a cross-sectional shape of the path of the charged particle beam at the aperture array.

Clause 29: The apparatus of clause 28, wherein the at least one charged-particle-optical component comprises at least two facing surfaces for the compensation of variations in distance between the emitter and the aperture array, desirably the at least two facing surfaces are around the divergent path.

Clause 30: The apparatus of clause 29, wherein the at least one charged-particle-optical component comprises an electrostatic element configured to operate on the divergent path between the at least two facing surfaces, wherein desirably the electrostatic element comprises a planar electrode and/or comprise a coil around the divergent beam path.

Clause 31: A charged-particle apparatus configured to generate a plurality of sub-beams from a divergent beam of charged particles and direct the sub-beams downbeam toward a sample position, the charged-particle apparatus comprising; a charged-particle source comprising an emitter configured to emit a beam of charged particles along a divergent path; an aperture array in which are defined apertures and positioned in the divergent path, the aperture array configured to generate sub-beams from the beam along the divergent path; and at least one charged-particle-optical component configured to act on the beam of charged particles upbeam of the aperture array; wherein the at least one charged-particle-optical component comprises: at least a multipole arranged around the divergent path configured to operate as a deflector and/or as a stigmator of the divergent path of the charged particle beam; and/or two facing surfaces around the divergent beam path configured to operate as a charged-particle-optical lens.

Clause 32: The charged-particle apparatus of clause 31, wherein the deflector is configured to operate on the divergent path of the beam so as to vary the position of the divergent path at the aperture array.

Clause 33: The charged-particle apparatus of clause 31 or 32, wherein the stigmator is configured to vary a cross-sectional shape of the path of the charged particle beam at the aperture array.

Clause 34: The charged-particle apparatus of any of clauses 31 to 33, wherein the charged-particle-optical lens is configured to compensate for variations in distance between the emitter and the aperture array.

Clause 35: The charged-particle apparatus of any of clauses 31 to 34, wherein at least one multipole configured to operate as a deflector is the same as the at least one multiple configured to operate as a stigmator.

Clause 36: The charged-particle apparatus of any of clauses 31 to 35, wherein at least one multipole configured to operate as a deflector is different from at least one multipole configured to operate as a stigmator.

Clause 37: The charged-particle apparatus of any of clauses 31 to 36, comprising a controller configured to control the at least one charged-particle-optical component or at least one of the deflector, stigmator and/or lens.

Clause 38: The charged-particle apparatus of any of clauses 29 to 37, wherein at least one of the two facing surfaces is of a plate in which is defined an aperture for the divergent path.

Clause 39: The charged-particle apparatus of any of clauses 29 to 38, wherein at least one multipole is downbeam of an extractor electrode of the source.

Clause 40: The charged-particle apparatus of any clauses 29 to 39, wherein at least one multipole is downbeam of at least one of the facing surfaces.

Clause 41: The charged-particle apparatus of any of clauses 29 to 40, wherein at least one multipole is upbeam of the two facing surfaces.

Clause 42: The charged-particle apparatus of any of clauses 29 to 41, wherein the two facing surfaces are between two multipoles along the divergent path.

Clause 43: The charged-particle apparatus of any of clauses 29 to 42, wherein at least one of the two facing surfaces is provided by a surface of at least one of the multipoles facing in the direction towards or away from the sample position.

Clause 44: The charged-particle apparatus of any of clauses 29 to 43, comprising a controller configured to control the at least one charged-particle-optical component based on information of the charged particle beam.

Clause 45: The charged-particle apparatus of clause 44, comprising a detector configured to detect the charged particle beam and/or one or more sub-beams so as to obtain the information.

Clause 46: A multi-device apparatus comprising multiple devices each configured to project a plurality of sub-beams of charged particles towards a sample position, the multi-device apparatus comprising a charged-particle apparatus of any preceding clause comprising a plurality of the sources and a plurality of corresponding charged-particle-optical devices each comprising the aperture array and the at least one charged-particle-optical component.

Clause 47: The multi-device apparatus of clause 46, comprising a controller configured to control the at least one charged-particle-optical component of the plurality of charged-particle-optical devices to control a parameter of the plurality of the beams at the corresponding aperture arrays, preferably the parameter is the source beam uniformity, preferably at the corresponding aperture arrays, so as to control the source beam uniformity across the plurality of sources.

Clause 48: A method of using a charged-particle apparatus to generate a plurality of sub-beams from a source beam of charged particles and direct the sub-beams downbeam toward a sample position, the method comprising; emitting a source beam of charged particles along a divergent path; generating sub-beams from the source beam at an aperture array; and using a charged-particle-optical component to act on the divergent path upbeam of the aperture array; wherein the at least one charged-particle-optical component comprises: at least one multipole configured to operate on the source beam so as to vary the position of the divergent path at the aperture array and/or to vary a cross-sectional shape of the divergent path at the aperture array, and/or a charged-particle-optical lens configured to compensate for variations in distance between the emitter and the aperture array.

Clause 49: A method of controlling a divergent path of a charged particle beam over an aperture array for generating a plurality of sub-beams toward a sample position in a charged-particle apparatus, the method comprising; emitting a beam of charged particles along a divergent path; operating on the divergent path upbeam of an aperture array in which are defined a plurality of apertures, each aperture corresponding to a generated sub-beam; and generating sub-beams from the divergent beam at the aperture array; wherein the operating on the divergent path comprises at least one of varying a position of the divergent path at the beam generator, compensating variations in distance between the emitter and the aperture array, and varying a shape of the divergent beam at the aperture array.

Clause 50: The method of clause 48 or 49, comprising controlling the operating on the divergent path based on information of the charged particle beam.

Clause 51: The method of clause 50, wherein the information of the charged particle beam comprises information of one more of the sub-beams.

Clause 52: The method of clause 50 or 51, comprising detecting the beam so as to obtain the information of the charged particle beam.

Clause 53: The method of clause any of clauses 50 to 52, wherein the information relates to one more of the position of the divergent path at the beam generator, distance between the emitter and the aperture array, and the shape of the divergent beam for example at the aperture array.

Clause 54: The method of clause any of clauses 50 to 53, wherein the information relates to one more parameters such as the profile and/or the current, of one or more sub-beams.

## Claims

1. A charged-particle apparatus configured to generate a plurality of sub-beams from a source beam of charged particles and direct the sub-beams downbeam toward a sample position, the charged-particle apparatus comprising;
a charged-particle source comprising an emitter configured to emit a source beam of charged particles along a divergent path;
an aperture array in which are defined apertures and positioned in the divergent path, the aperture array configured to generate sub-beams from the source beam; and
at least one charged-particle-optical component configured to act on the source beam of charged particles upbeam of the aperture array;
wherein the at least one charged-particle-optical component comprises:
at least one multipole configured to operate on the source beam so as to vary the position of the divergent path at the aperture array and/or to vary a cross-sectional shape of the divergent path at the aperture array, and/or
a charged-particle-optical lens configured to compensate for variations in distance between the emitter and the aperture array.

2. The charged-particle apparatus of claim 1, comprising:
a controller configured to control the at least one charged-particle-optical component so as to control at least one property of the source beam on the aperture array.

3. The charged-particle apparatus of claim 2, wherein the at least one property comprises at least one of divergence, uniformity of current, uniformity of brightness, and uniformity of divergence.

4. The charged-particle apparatus of claim 2 or 3, wherein the controller is configured to control the at least one charged-particle-optical component based on a measurement signal containing information about the source beam and/or the sub-beams.

5. The charged-particle apparatus of claim 4, comprising a detector configured to monitor the source beam and/or the sub-beams.

6. The charged-particle apparatus of claim 5, wherein the detector is configured to generate the measurement signal.

7. The charged-particle apparatus of claim 5 or 6, wherein the detector is at least one of:
a detector array configured to detect signal particles generated by the sub-beams on a sample, the detector array desirably facing the sample position; and/or
a sensor system configured to detect at least part of the source beam and/or of one or more sub-beams.

8. The charged-particle apparatus of any of claims 2 to 7, wherein the controller is configured to control the at least one charged-particle-optical component so as to control a preferred portion of the source beam to cover the apertures of the aperture array.

9. The charged-particle apparatus of claim 8, wherein the preferred portion of the source beam is determined based on information about the source beam and/or the sub-beams.

10. The charged-particle apparatus of any of claims 2 to 9, wherein the controller is configured to control the at least one charged-particle-optical component so as to compensate for change in the divergent path between the emitter and the aperture array, the change in the divergent path comprising at least one of: movement of the source beam relative to the aperture array, change in a shape of the emitter, and/or change in emission distribution.

11. The charged-particle apparatus of claim 10, wherein the movement of the source beam corresponds to a shift in the position of the emitter relative to the aperture array and/or a tilt of the emitter relative to the aperture array.

12. The charged-particle apparatus of any preceding claim, wherein the at least one charged-particle-optical component comprises a charged-particle-optical lens configured to vary an angle of divergence of the source beam and/or a proportion of coverage of the aperture array by the source beam.

13. The charged-particle apparatus of any preceding claim, wherein the at least one charged-particle-optical component comprises a stigmator configured to vary a shape of the source beam on the aperture array.

14. The charged-particle apparatus of any preceding claim, the charged-particle source comprising an extractor electrode downbeam of the emitter.and
wherein the at least one charged-particle-optical component is downbeam of the extractor electrode.

15. The charged-particle apparatus of any preceding claim, wherein the at least one charged-particle-optical component comprises at least one electrostatic component and/or at least one electromagnetic component.
